# EUROPEAN PATENT APPLICATION

(11) **EP 2 211 374 A1**
(43) Date of publication of application: **28.07.2010**
(21) Application number: 08850923.7
(22) Date of filing: 13.11.2008
(51) Int. Cl.: H01L 21/3065, H01L 31/04, H01L 33/00

(54) **SUBSTRATE PROCESSING METHOD AND SUBSTRATE PROCESSED BY THIS METHOD**

(30) Priority: 16.11.2007 JP 2007297810
(71) Applicant: ULVAC, INC., Chigasaki-shi, Kanagawa 2538543 (JP)
(72) Inventor: SAKIO, Susumu, Sammu-shi Chiba 2891226 (JP); TAKEI, Hideo, Sammu-shi Chiba 2891226 (JP); SAITO, Kazuya, Sammu-shi Chiba 2891226 (JP); WATANABE, Kazuhiro, Susono-shi Shizuoka 4101231 (JP); IGUCHI, Shinsuke, Chigasaki-shi Kanagawa 2538543 (JP); YAMAKAWA, Hiroyuki, Chigasaki-shi Kanagawa 2538543 (JP); NAKAMURA, Kyuzou, Chigasaki-shi Kanagawa 2538543 (JP); LIN, Yu-shin, x (JP); CHANG, Huang.choung, x (JP); WU, Tung-jung, x (JP)
(74) Representative: Albutt, Anthony John
(86) International application number: PCT/JP2008/070713
(87) International publication number: WO 2009/063954

(57) **Abstract**

[Object] To provide a substrate processing method capable of forming a concavo-convex structure on a substrate surface while reducing the number of processes.

[Solving Means] In a substrate processing method according to the present invention, particles (11) are dispersed on a surface (10s) of a substrate (10), and a concavo-convex structure (12) is formed on the surface of the substrate by etching the surface of the substrate with the particles as a mask and the mask (11) is simultaneously removed by the etching. According to this method, a process of removing the mask (11) from the substrate surface (10s) after the concavo-convex structure (12) is formed becomes unnecessary. Accordingly, since the number of processes necessary to form the concavo-convex structure on the substrate surface is largely reduced, it becomes possible to greatly improve productivity.

## Description

### Technical Field

The present invention relates to a substrate processing method for forming a fine concavo-convex structure on a surface of a substrate, and a substrate processed by this method.

### Background Art

In recent years, the development of a solar cell device has progressed actively. A solar cell includes a photoelectric conversion layer. To enhance performance of the device, it is essential to efficiently introduce light into this photoelectric conversion layer. Specially, it is known that a fine concavo-convex structure is formed on a light-incident surface of the device and light reflection on an interface is reduced as much as possible (see Patent Documents 1 and 2, for example).

As a method of forming a fine concavo-convex structure on a surface of a substrate, Patent Document 1 discloses a method of pattern-drawing a resist material on a substrate surface by an ink-jet method and then etching the substrate with the resist material as a mask. Moreover, Patent Document 2 discloses a method of etching the substrate with silica fine particles dispersed on the surface of the substrate as a mask and then removing the remaining fine particles.

Patent Document 1: Japanese Patent Application Laid-open No. 2006-210394
Patent Document 2: Japanese Patent Application Laid-open No. 2000-261008

### Disclosure of the Invention

### Problem to be solved by the Invention

However, in the conventional substrate processing method using the resist material or silica fine particles as the etching mask, a process of removing the mask that remains on the substrate surface is needed after the etching process. Accordingly, the number of processes necessary for the substrate processing cannot be largely reduced and there arises a problem that productivity cannot be improved.

In view of the circumstances as described above, it is an object of the present invention to provide a substrate processing method capable of forming a concavo-convex structure on a substrate surface while reducing the number of processes.

### Means for solving the Problem

A substrate processing method according to a mode of the present invention includes dispersing particles on a surface of a substrate, and forming a concavo-convex structure on the surface of the substrate by etching the surface of the substrate with the particles as a mask and simultaneously removing the mask by the etching.

### Best Mode for Carrying Out the Invention

A substrate processing method according to an embodiment of the present invention includes dispersing particles on a surface of a substrate, and forming a concavo-convex structure on the surface of the substrate by etching the surface of the substrate with the particles as a mask and simultaneously removing the mask by the etching.

According to this method, a process of removing the mask from the substrate surface after the concavo-convex structure is formed becomes unnecessary. Accordingly, since the number of processes necessary to form the concavo-convex structure on the substrate surface is largely reduced, it becomes possible to greatly improve productivity.

As methods of dispersing particles on the substrate surface, any method of a dry dispersion method and a wet dispersion method is applicable. The dry dispersion method refers to a method of spraying particles together with a compressed gas on the substrate. The wet dispersion method refers to a method of applying a solvent containing particles to the substrate using a spin coater, a dispenser, an ink-jet nozzle, or the like.

A shape, a size, a constituent material, and the like of the particles that are dispersed on the surface of the substrate are not particularly limited, and are selected as appropriate in accordance with a form of a concavo-convex structure to be formed on the substrate. In the present invention, the particles are not particularly limited as long as they are a material capable of being etched simultaneously with a substrate material at a time the substrate is etched. For example, an organic material such as polystyrene and a divinylbenzene copolymer can be used. Etching is carried out by dry etching (plasma etching), but may be carried out by wet etching.

A finer concavo-convex structure can be formed as a particle diameter of the particles becomes smaller. The particle diameter (diameter) is, for example, 0.01 µm or more to 10 µm or less. An etching rate of the particles may be lower or higher than an etching rate of the substrate. In other words, the particles can be constituted by a material in which an optimum etching selectivity ratio is obtained in accordance with a depth of concave portions of a concavo-convex structure to be formed.

By carrying out the substrate processing method of the present invention, it is possible to form a fine concavo-convex structure on the surface of the substrate. The substrate processed as described above can be used as a sapphire substrate for a light-emitting diode that is formed with a light-emitting layer on the surface or a silicon substrate for a solar cell that is formed with a photoelectric conversion layer on the surface.

Hereinafter, an embodiment of the present invention will be described with reference to the drawings.

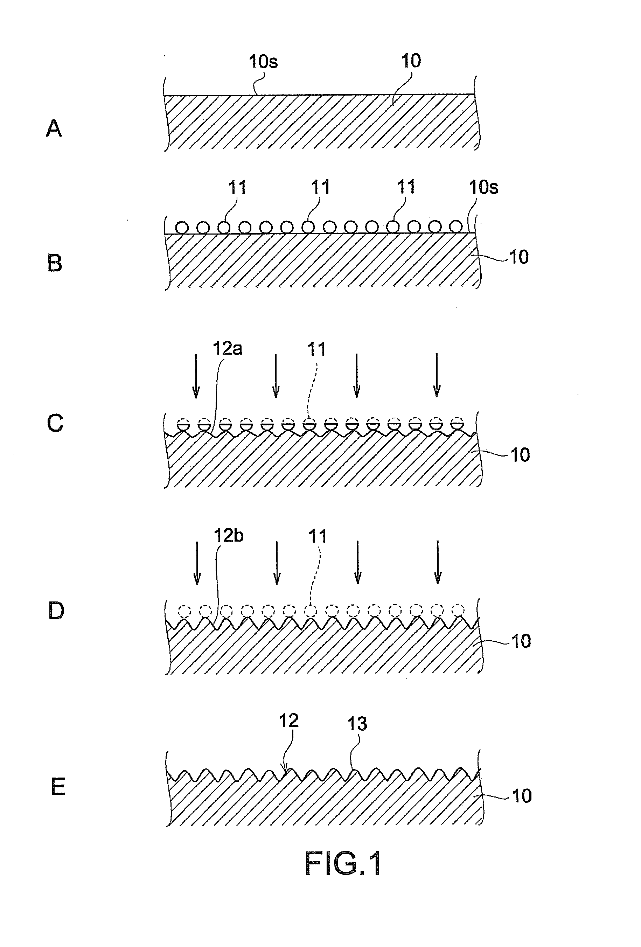

Figs. 1 are schematic process diagrams for explaining a substrate processing method according to an embodiment of the present invention.

As shown in Fig. 1A, a substrate 10 having a surface 10s on which a fine concavo-convex structure is to be formed is first prepared. Though the surface 10s is a flat surface, it may be a curved surface or a wavy surface. A silicon substrate, a sapphire substrate, or the like is used as the substrate 10, but instead thereof, a glass substrate, a plastic substrate, a metal substrate, or the like is used.

Next, fine particles 11 are dispersed on the surface 10s of the substrate 10 as shown in Fig. 1B. The fine particles 11 are particles having a particle diameter of 0.01 µm or more to 10 µm or less, and function as a mask in an etching process performed later. In this embodiment, the fine particles 11 are formed of an insulating organic material such as polystyrene and a divinylbenzene copolymer. It should be noted that the particle diameters of the dispersed fine particles 11 are not limited to be the same size, and the fine particles 11 may be mixed particles that are constituted of fine particles having different particle diameters.

A dry dispersion method can be used for the dispersion of the fine particles 11. In the dry dispersion method, the fine particles 11 are sprayed together with a compressed gas on the substrate from a nozzle (not shown) connected to a tip of a relatively thin pressure feed pipe. At this time, the fine particles 11 are dispersed by being moved by high-velocity airflow within the pressure feed pipe and charged by a friction with an inner wall of the pressure feed pipe. The charged fine particles 11 are sprayed out from the nozzle and adhere to the substrate surface 10s due to an electrostatic force. At this time, since the fine particles 11 do not discharge immediately after adhering to the substrate 10, the fine particles repel one another on the substrate and adhere to the substrate without reaggregating while keeping a constant interval as shown in Fig. 1B.

Further, a wet dispersion method can also be used for the dispersion of the fine particles 11. In this case, the fine particles are mixed into a solvent such as water and alcohol and the mixed solution is applied all over the substrate surface 10s using a spin coater, or applied at predetermined positions of the substrate surface 10s in a point-like manner using a dispenser nozzle or an ink-jet nozzle (head).

The fine particles 11 each adhere to the substrate surface 10s at constant intervals or larger therebetween. The intervals between the fine particles 11 are not limited to be constant. The number of fine particles 11 per unit area (square meter) (dispersion density) differs depending on the particle diameter of the fine particles 11. For example, the dispersion density in a case where the particle diameter is 0.01 µm to 0.1 µm is 2×10⁹ to 2×10¹⁰, the dispersion density in a case where the particle diameter is 0.1 µm to 1 µm is 2×10⁷ to 2×10⁸, and the dispersion density in a case where the particle diameter is 1 µm to 10 µm is 2×10⁵ to 2×10⁶.

It should be noted that a dispersion area of the fine particles 11 is not limited to be the whole area of the substrate surface, and may be a part of the substrate surface.

Subsequently, the surface 10s of the substrate 10 is etched with the dispersed fine particles 11 as a mask. In this embodiment, etching is carried out by dry etching (plasma etching). In this etching process, after the substrate 10 to which the fine particles 11 adhere is mounted to an etching chamber (not shown), a pressure inside the chamber is reduced to a predetermined degree of vacuum. Then, by introducing an appropriate etching gas into the chamber in accordance with respective constituent materials of the substrate 10 and the fine particles 11 and generating the plasma of the etching gas, etching is carried out on the substrate surface 10s with the fine particles 11 as a mask.

As methods of generating plasma of an etching gas, there are various systems such as an inductively-coupled (ICP) type, a capacitively-coupled (CCP) type, and an electron cyclotron resonance (ECR) type, but any system may be adopted. Further, ions in plasma may be periodically irradiated onto the substrate by applying a high-frequency bias power to the substrate 10. As the etching gas, a fluorine-based gas such as SF₆, NF₃, and CoF₂ can be used in a case where the substrate 10 is a silicon substrate, and a fluorocarbon-based gas such as CHF₃ can be used in addition to a chlorine-based gas such as Cl₂ in a case where the substrate 10 is a sapphire substrate.

In the etching process of the substrate 10, the fine particles 11 function as etching mask. Accordingly, as shown in Fig. 1C, a surface area of the substrate 10 to which the fine particles 11 do not adhere is selectively etched to form concave portions 12a. On the other hand, the fine particles 11 are also etched simultaneously with this etching process as shown in the figure. As a result, a thickness of the mask is reduced.

When the etching further progresses, the concave portions formed on the substrate surface 10s become deeper accordingly, and the mask 11 is removed by that etching processing at a time when concave portions 12b having a predetermined depth are formed as shown in Fig. 1D. The depth of the concave portions 12b is controlled by etching conditions, a constituent material of the fine particles 11 as a mask, and the like.

As described above, a concavo-convex structure 12 is formed on the surface 10s of the substrate 10 (Fig. 1E). According to this embodiment, a process of removing the mask 11 from the substrate surface 10s becomes unnecessary after the concavo-convex structure 12 is formed. Accordingly, since the number of processes necessary to form the concavo-convex structure 12 on the substrate surface 10s is largely reduced, it becomes possible to largely improve a processing efficiency, that is, productivity of the substrate 10.

Further, according to this embodiment, it becomes possible to control the depth of the concave portions 12b formed on the substrate surface 10s, a pitch (distance between adjacent concave portions), and the like by a particle diameter of the fine particles 11 used as a mask, and easily obtain a desired concavo-convex structure 12. For example, since intervals between the fine particles 11 that adhere to the substrate surface 10s can be made smaller as the particle diameter of the fine particles 11 is made smaller, a pitch between the concave portions 12b to be formed becomes narrow.

Moreover, the depth or pitch of the concave portions 12b can also be controlled by an etching selectivity ratio of the fine particles 11 with respect to the substrate 10. For example, in a case where a material whose etching rate is higher than the substrate 10 is used as the fine particles 11, etching resistance of the fine particles 11 is lowered and accordingly relatively shallow concave portions are formed on the substrate surface 10s. On the other hand, in a case where a material whose etching rate is lower than the substrate 10 is used as the fine particles 11, a processing time during which the substrate surface is being etched up until the fine particles 11 disappear by etching becomes longer, and therefore relatively deep concave portions are formed on the substrate surface 10s.

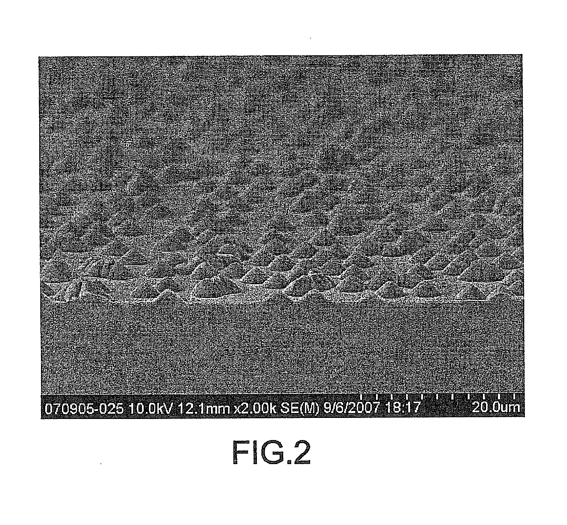

Fig. 2 is a SEM photograph of a sample that has been obtained as a result of carrying out the above substrate processing method according to the present invention. A state where convex portions are formed at random on the surface is shown. A formation area of those convex portions corresponds to the area to which the fine particles as a mask adhere. It should be noted that the substrate was made of sapphire and polystyrene particles having a particle diameter of 0.1 µm to 4 µm were used as fine particles for a mask.

A shape of convex portions 13 (Fig. 1E) that forms the concavo-convex structure is not limited particularly. Fig. 3 shows a convex portion 13A having a hemispherical shape, and Figs. 4A and 4B show a convex portion 13B having a conical shape. Moreover, Figs. 5A and 5B show a convex portion 13C having a warhead-like shape or a bell-like shape, and Figs. 6A and 6B show a convex portion 13D having a circular truncated cone-like shape. The shapes of those convex portions can be controlled by constituent materials of the substrate 10 and the fine particles 11 and etching conditions (etching time, etching pressure, etching gas, etc.), and can be arbitrarily selected in accordance with a type of an applied device.

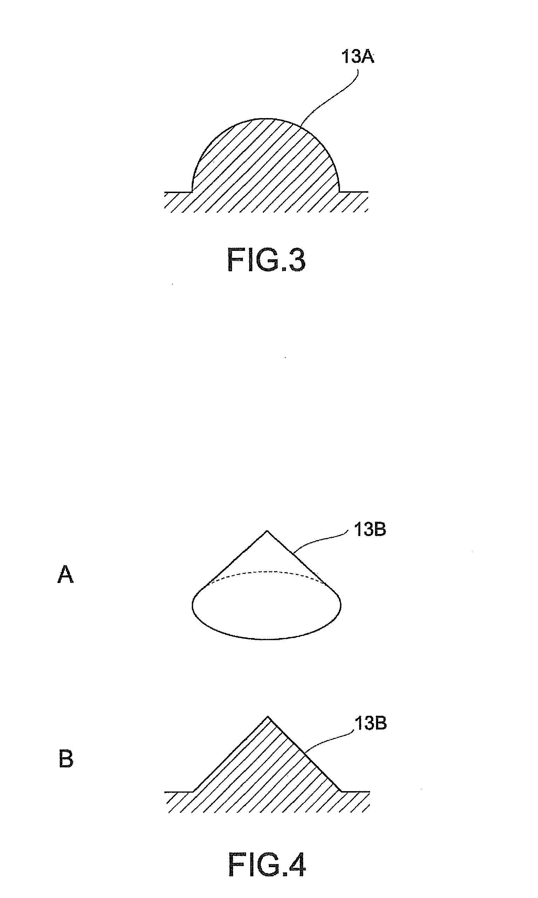

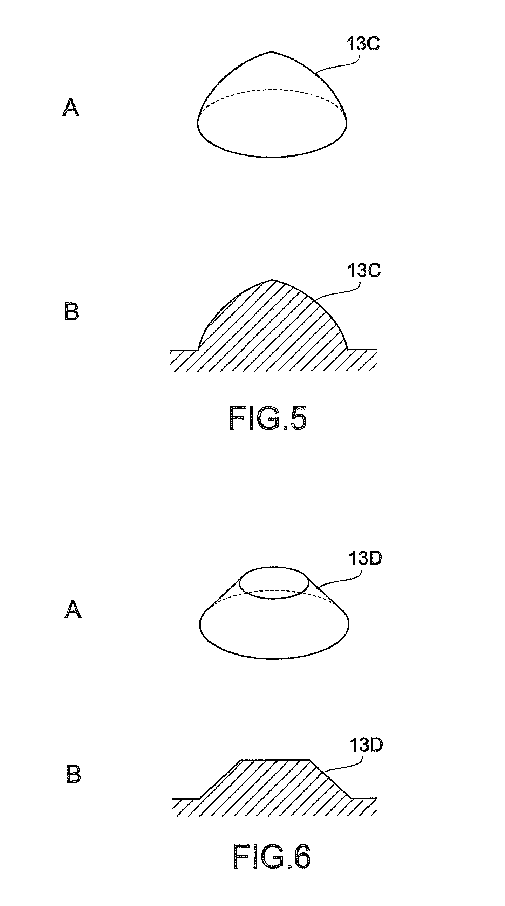

It should be noted that in the convex portions 13B and 13D in which a linear tilted surface is formed on a side portion as shown in Figs. 4 and 6, a taper angle of that tilted surface is not particularly limited and is, for example, 45 degrees to 80 degrees.

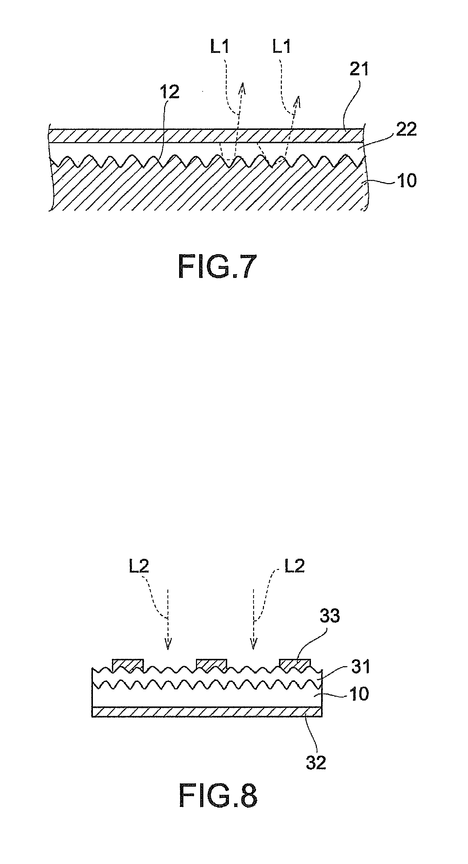

Figs. 7 and 8 are schematic structure diagrams of an optical device that uses the substrate 10 whose surface has been subjected to the processing of forming the concavo-convex structure described above.

Fig. 7 shows an application example to a surface-emitting diode. The substrate 10 is made of a sapphire substrate and a light-emitting layer 21 is laminated on a surface on which the concavo-convex structure 12 is formed via a buffer layer 22. The light-emitting layer 21 is formed of a gallium nitride-based semiconductor light-emitting layer, for example. Light generated in the light-emitting layer 21 is mainly emitted to a front side (upper side in the figure). Light L1 emitted to a back side of the light-emitting layer 21 (lower side in the figure) is transmitted through the buffer layer 22 and reflected on the surface of the substrate 10.

Since the fine concavo-convex structure 12 is formed on the surface of the substrate 10 in the example of the figure, the light L1 emitted from the light-emitting layer 21 to the back side is oriented to the front side by reflection or refractive transmission due to the concavo-convex structure 12 on the substrate surface. Accordingly, since light-collecting performance of the light-emitting layer 21 to the front side is enhanced, it becomes possible to improve a light extraction efficiency.

On the other hand, Fig. 8 shows an application example to a solar cell. The substrate 10 is made of a silicon substrate and constitutes a p-type semiconductor layer, for example. On a surface of the substrate 10, an n-type semiconductor layer 31 is formed. Those p-type semiconductor layer (substrate) 10 and n-type semiconductor layer 31 constitute a photoelectric conversion layer. A back electrode 32 is formed on a back side of the substrate 10 and a front electrode 33 is pattern-formed on a surface of the n-type semiconductor layer 31. Outside light (sunlight) L2 enters the photoelectric conversion layer from the surface side of the n-type semiconductor layer 31 and is converted into a voltage corresponding to incident energy in the photoelectric conversion layer. The generated voltage is taken out to the outside by the back electrode 32 and the front electrode 33 to be stored.

Since the fine concavo-convex structure 12 is formed on the surface of the substrate 10 in the example of the figure, the fine concavo-convex structure is also formed on an interface with the n-type semiconductor layer 31 formed on the surface of the substrate 10 and the surface of the n-type semiconductor layer 31. Though schematically shown in the figure, the concavo-convex structure is preferably formed with a concavo-convex pitch that is equal to or smaller than a wavelength of incident light. With this structure, it becomes possible to largely lower a light reflectance on the surface of the n-type semiconductor layer 31, increase a light amount of outside light that enters the photoelectric conversion layer, and improve a conversion efficiency.

It should be noted that the present invention is not limited to the above embodiment and various modifications can of course be added within a range without departing from the gist of the present invention.

For example, the concavo-convex structure is formed on the surface of the substrate 10 in the above embodiment, but the present invention can also be applied to a case where the concavo-convex structure is formed on a surface of a layer or film that is formed on the surface of the substrate 10. For example, the present invention can also be carried out suitably in a case where the concavo-convex structure is imparted to a native oxide film formed on a surface of a silicon substrate or a transparent electrode film formed on a surface of a glass substrate.

### Brief Description of Drawings

[Figs. 1] Schematic process diagrams for explaining a substrate processing method according to an embodiment of the present invention.
[Fig. 2] A SEM photograph showing an example of a concavo-convex structure formed by the substrate processing method according to the present invention.
[Fig. 3] A cross-sectional diagram showing an example of a shape of a convex portion constituting the concavo-convex structure.
[Figs. 4] Diagrams showing another example of a shape of the convex portion constituting the concavo-convex structure, in which A is a perspective diagram and B is a cross sectional diagram.
[Figs. 5] Diagrams showing still another example of a shape of the convex portion constituting the concavo-convex structure, in which A is a perspective diagram and B is a cross sectional diagram.
[Figs. 6] Diagrams showing still another example of a shape of the convex portion constituting the concavo-convex structure, in which A is a perspective diagram and B is a cross sectional diagram.
[Fig. 7] A schematic structure diagram of a device that explains an application example of a substrate processed by the substrate processing method according to the present invention.
[Fig. 8] A schematic structure diagram of another device that explains an application example of the substrate processed by the substrate processing method according to the present invention.

### Description of Symbols

10 substrate
11 fine particles (mask)
12 concavo-convex structure
12a, 12b concave portion
13, 13A, 13B, 13C, 13D convex portion

## Claims

1. A substrate processing method, comprising:
dispersing particles on a surface of a substrate; and
forming a concavo-convex structure on the surface of the substrate by etching the surface of the substrate with the particles as a mask and simultaneously removing the mask by the etching.

2. The substrate processing method according to claim 1,
wherein the particles are organic materials.

3. The substrate processing method according to claim 2,
wherein a particle diameter of the particle is 0.01 µm or more to 10 µm or less.

4. The substrate processing method according to claim 1,
wherein the substrate is a sapphire substrate for a light-emitting diode that is formed with a light-emitting layer on the surface.

5. The substrate processing method according to claim 1,
wherein the substrate is a silicon substrate for a solar cell that is formed with a photoelectric conversion layer on the surface.

6. A substrate, comprising:
a surface on which particles are dispersed; and
a concavo-convex structure that is formed on the surface by carrying out etching processing with the particles as a mask and removing the particles.
